Europäisches Patentamt

European Patent Office

Office européen des brevets

(11) Numéro de publication: **0 412 002 A1**

# (12) DEMANDE DE BREVET EUROPEEN

(21) Numéro de dépôt: 90402189.6

(22) Date de dépôt: **31.07.90**

(51) Int. Cl.5: **H01L 21/20, C30B 31/22**

(30) Priorité: **01.08.89 FR 8910363**

(43) Date de publication de la demande:
**06.02.91 Bulletin 91/06**

(84) Etats contractants désignés:
**DE GB NL**

(71) Demandeur: **THOMSON-CSF**
**51, Esplanade du Général de Gaulle**
**F-92800 Puteaux(FR)**

(72) Inventeur: **Bisaro, René**
**Thomson-CSF, SCPI - Cédex 67**
**F-92045 Paris La Défense(FR)**
Inventeur: **Friederich, Alain**
**Thomson-CSF, SCPI - Cédex 67**
**F-92045 Paris La Défense(FR)**

(74) Mandataire: **Ruellan-Lemonnier, Brigitte et al**
**THOMSON-CSF SCPI**
**F-92045 PARIS LA DEFENSE CEDEX 67(FR)**

(54) **Procédé d'hétéroépitaxie.**

(57) La présente invention concerne un procédé de fabrication par épitaxie de couches monocristallines de matériaux à paramètres de maille différents.

Le procédé comporte les étapes suivantes :
- une première étape de dépôt par épitaxie sur une première couche (1) en un matériau présentant un paramètre de maille déterminée, d'une deuxième couche (2) d'épaisseur déterminée en un matériau présentant un paramètre de maille différent de celui de la première couche,
- une deuxième étape d'implantation ionique de manière à créer dans la deuxième couche une zone (4) limitant la propagation des dislocations, et au moins
- une troisième étape de dépôt par épitaxie sur la deuxième couche d'une troisième couche (5) réalisée dans le même matériau que celui de la deuxième couche.

l'invention s'applique notamment à la fabrication de dispositifs optoélectroniques ou hyperfréquences réalisés en AsGa sur substrat Si.

FIG_2

## PROCEDE DE FABRICATION PAR EPITAXIE DE COUCHES MONOCRISTALLINES DE MATERIAUX A PARAMETRES DE MAILLE DIFFERENTS

La présente invention concerne un procédé de fabrication de couches monocristallines de matériaux à paramètres de maille différents.

En général pour réaliser des dispositifs semi-conducteurs, on fait croître par épitaxie au moins une couche monocristalline sur un substrat. Or, cette croissance par épitaxie d'un matériau sur un substrat est très difficile lorsque le désaccord des paramètres de maille réticulaire est très important. Cependant, pour des raisons de coût et de caractéristiques techniques spécifiques, on souhaite de plus en plus utiliser comme substrat le silicium ou d'autres matériaux de même type dans la fabrication de dispositifs opto-électroniques tels que les lasers, photodiodes, photocathodes ou similaire et de dispositifs hyperfréquences tels que les diodes GUNN, diodes INPATT, transistors FET qui sont réalisés à l'aide des composés III/V de la classification périodique des éléments, ou de détecteurs infra-rouge réalisés à l'aide de structures à multipuits quantiques de matériaux III-V, ou à l'aide de composés II/VI ou IV/VI de la classification périodique des éléments. Ainsi, le désaccord des paramètres de maille réticulaire donné par l'écart $\delta$ a/a est de 4,1 % entre l'arséniure de gallium et le silicium, et de 8,1 % entre le phosphure d'indium et le silicium. En conséquence, au cours de la croissance il se crée des dislocations. En effet l'énergie par unité d'interface entre les deux matériaux augmentant proportionnellement avec l'épaisseur de la couche, pour une épaisseur critique donnée, il devient énergiquement plus favorable de créer une dislocation que de continuer l'épitaxie sous contrainte de compression biaxiale anisotrope. Or, un certain nombre de dislocations traverse la couche, ce qui est extrêmement gênant pour le bon fonctionnement des dispositifs réalisés sur ces couches épitaxiées. Ainsi, dans le cas d'une épitaxie de GaAs sur du silicium, $10^{12}$ dislocations par $cm^2$ sont créées dont $10^6$ par $cm^2$ au moins ne sont pas localisées au voisinage de l'interface.

Il existe actuellement différents procédés qui visent à réduire le nombre des dislocations dans la partie supérieure de la couche. Parmi ces procédés, on peut citer l'utilisation de cycles de recuit thermique réalisés ex-situ qui modifie la direction des lignes de dislocations sans en modifier le nombre, l'utilisation de cycles de recuit in-situ qui améliore considérablement le taux de dislocations s'ils sont réalisés après environ 1000 Å de croissance à basse température sans pourtant les diminuer au delà de la valeur critique, l'utilisation de super-réseaux entre le substrat et les couches monocristallines, l'utilisation de structures à puits quantiques dont l'efficacité est limitée lorsque le taux de dislocations est très important ou l'utilisation de cycles de croissance couplés ou non avec des cycles de recuit. Toutefois, aucun de ces procédés n'a permis d'abaisser le taux de dislocations en-dessous d'une valeur de $10^6$ par $cm^2$.

La présente invention a donc pour but de proposer un nouveau procédé de fabrication par épitaxie de couches monocristallines de matériaux à paramètres de maille très différents qui permet de réduire considérablement le nombre de dislocations se propageant dans la couche en formation.

Ainsi la présente invention a pour objet un procédé de fabrication de couches monocristallines de matériaux à paramètres de maille différents dans lequel on dépose par épitaxie sur une première couche en un matériau présentant un paramètre de maille déterminé au moins une couche monocristalline supplémentaire en un matériau présentant un paramètre de maille différent de celui de la couche adjacente, caractérisé en ce que l'on crée par implantation ionique en son sein ou au niveau de la jonction entre deux couches au moins une zone limitant la propagation des dislocations.

Ainsi, par implantation d'ions ou de protons, on crée soit des points d'ancrage pour les dislocations évitant leur propagation vers la surface, soit des zones de contraintes permettant de courber les dislocations, soit une zone amorphe découplant mécaniquement le substrat de la couche épitaxiée rendant la plaquette in fine moins contrainte et courbée.

Selon un premier mode de réalisation spécifique, le procédé conforme à la présente invention comporte les étapes suivantes:
- une première étape de dépôt par épitaxie sur une première couche en un matériau présentant un paramètre de maille déterminé d'une deuxième couche d'épaisseur déterminée en un matériau présentant un paramètre de maille différent de celui de la première couche,
- une deuxième étape d'implantation ionique de manière à créer dans la deuxième couche une zone limitant la propagation des dislocations, et au moins
- une troisième étape de dépôt par épitaxie sur la deuxième couche d'une troisième couche réalisée dans le même matériau que celui de la deuxième couche.

De préférence, avant la première étape de dépôt par épitaxie la première couche ou substrat est recouverte d'une précouche d'adaptation monomoléculaire. Cette précouche permet de lisser la surface du substrat et peut aussi réaliser un isolement électrique entre le substrat et la couche monocristalline, si elle est plus épaisse. Elle peut être de même nature que le substrat ou de nature différente.

Selon un autre mode de réalisation, le procédé conforme à la présente invention comporte les étapes suivantes :
- une première étape de dépôt sur une première couche ou substrat en un matériau présentant un paramètre de maille déterminé d'une précouche d'adaptation monomoléculaire,
- une deuxième étape d'implantation ionique de manière à créer en surface une zone perturbée limitant les dislocations, dans la deuxième couche (étape 4),
- une troisième étape de nettoyage, et
- une quatrième étape de dépôt par épitaxie d'une deuxième couche en un matériau présentant un paramètre de maille différent de celui de la première couche.

Eventuellement le procédé ci-dessus comporte de plus
- une cinquième étape d'implantation ionique de manière à créer dans la deuxième couche une zone limitant la propagation des dislocations, et
- une sixième étape de dépôt par épitaxie sur la deuxième couche d'une troisième couche réalisée dans le même matériau que celui de la deuxième couche.

D'autres caractéristiques et avantages de la présente invention apparaîtront à la lecture de la description faite ci-après de divers modes de réalisation avec référence aux dessins ci-annexés, dans lesquels :
- les figures 1a à 1c représentent schématiquement un dispositif réalisé en suivant les principales étapes du procédé de la présente invention,
- la figure 2 représente un autre mode de réalisation de la présente invention,
- la figure 3 représente schématiquement encore un autre mode de réalisation de la présente invention, et
- les figures 4a à 4d représentent schématiquement les différentes étapes de réalisation d'un dispositif selon une variante du procédé de la présente invention.

Pour simplifier la description, dans les figures les mêmes éléments portent les mêmes références. D'autre part, dans un but de clarté, les épaisseurs des différentes couches réalisées par le procédé de la présente invention n'ont pas été respectées.

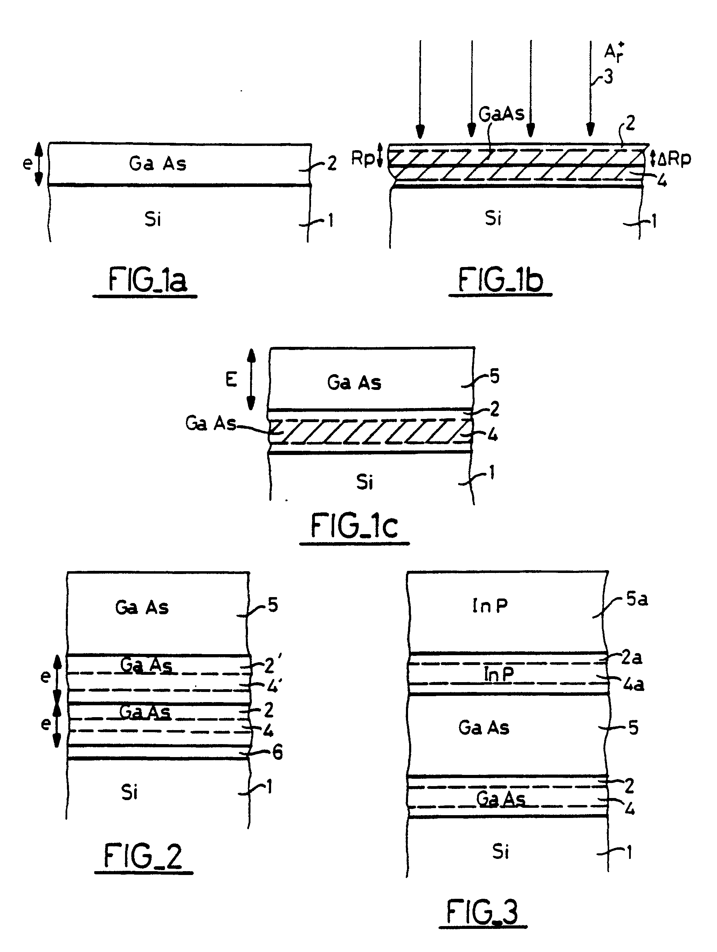

On décrira tout d'abord, avec référence aux figures 1a à 1c, le principe de base du procédé de la présente invention.

Comme représenté sur la figure 1a, conformément à la présente invention, sur une première couche ou substrat 1 qui peut être réalisé par exemple en silicium, en phosphure d'indium (InP), en arséniure de gallium (GaAs), en germanium ou en tout autre matériau présentant un paramètre de maille déterminé, on fait croître par épitaxie une deuxième couche 2 d'épaisseur contrôlée e d'un matériau présentant un paramètre de maille différent de celui du substrat. Dans le mode de réalisation représenté, on a fait croître une couche 2 d'arséniure de gallium (GaAs) sur du silicium (Si). La croissance d'arséniure de gallium a eu lieu sur une épaisseur e de 30000 Å. En fait, comme expliqué ci-après, l'épaisseur de la couche 2 est fonction de l'énergie et du type d'ions utilisés lors de l'étape suivante d'implantation ionique. Ensuite, on réalise éventuellement in-situ ou dans un autre dispositif, une implantation d'ions 3. Dans le mode de réalisation représenté on a utilisé des ions argon. D'autres types d'ions peuvent être utilisés, ces ions pouvant être des impuretés dopantes ou non tels que par exemple : le manganèse, l'aluminium, le silicium, le chrome, le fer, le nickel, le cobalt, le cuivre, le germanium, l'étain, le sélénium, le tellure, l'erbium, le vanadium, le béryllium, le zinc, le cadmium, le bore, le chlore, l'arsenic, le gallium, l'indium, le phosphore, le lithium, l'or, le tungstène, le carbone, le titane, l'argent, l'azote, l'oxygène, le soufre, l'hydrogène, le fluor, le brome ou même des protons, ou tous types d'ions susceptibles d'être implantés et de créer des défauts dans la première couche épitaxiée 2. Comme représenté sur la figure 1b, cette implantation d'ions crée des points d'ancrage pour les dislocations à une profondeur $R_P$ (R étant une grandeur fonction de l'ion et de l'énergie) et sur une largeur $2,35 \times \Delta R_P$ (représentant la largeur à mi-maximum de la distribution Gaussienne des ions implantés dans le matériau) de manière à former la zone perturbée 4. L'épaisseur de la couche GaAs est choisie pour avoir au-dessus de la zone perturbée 4, une couche présentant une cristallinité suffisante pour permettre une reprise d'épitaxie. A titre d'exemple l'épaisseur e est de 3000 Å dans le cas d'ions $Ar^+$ implantés sous une énergie de 300 KeV.

Eventuellement, avant de réaliser l'implantation ionique, on peut soumettre l'échantillon à un cycle de recuit thermique qui peut être réalisé dans le dispositif d'épitaxie ou non. Ce cycle de recuit thermique permet d'obtenir une précourbure des dislocations.

Puis, après l'implantation ionique, on reprend l'épitaxie sur une épaisseur E en utilisant le même matériau que celui de la deuxième couche, à savoir du GaAs dans le mode de réalisation décrit. Cette reprise d'épitaxie se fait à la température la plus basse possible poour éviter de guérir les défauts créés intentionnellement. On obtient l'échantillon représenté sur la figure 1c. Cet échantillon comporte une couche terminale 5 d'épaisseur E généralement comprise entre 2,5μ et 3,5μ.

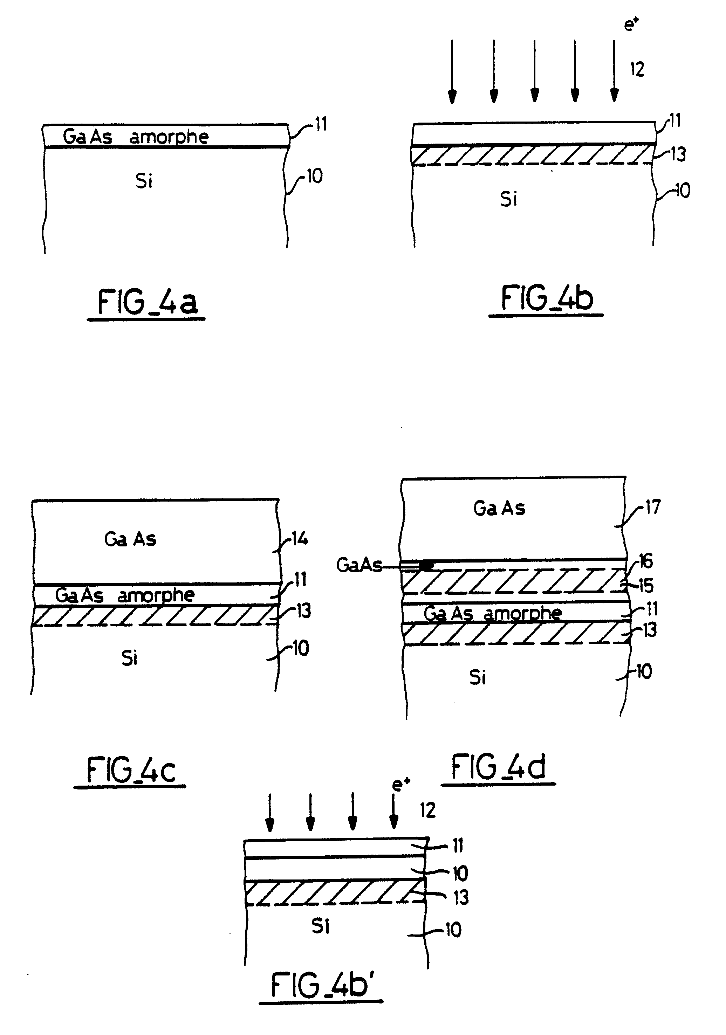

Comme représenté sur les figures 2 et 3, différentes variantes peuvent être apportées au procédé décrit ci-dessus. En particulier, avant de réaliser la première épitaxie, le substrat 1 peut être recouvert d'une précouche d'adaptation monomoléculaire ou plus épaisse 6. Cette précouche peut être réalisée soit en arsenic, soit en gallium, soit en AlAs, en $CaF_2$, $Ca_xSr_{(1-x)}F_2$, $Al_xGa_{(1-x)}As$, $Ga_x In_{(1-x)}P$, $Ga_xIn_{(1-x)}As$, $In_xGa_{(1-x)}As_{1-y}P_y$, ou en tout autre matériau habituellement utilisé pour ce type de précouche. D'autre part, comme représenté sur la figure 2, plusieurs zones perturbées superposées 4, 4' peuvent être formées. Dans ce cas, après avoir réalisé l'implantation ionique dans la deuxième couche 2, en GaAs par exemple, on reprend l'épitaxie d'une couche 2' sur une épaisseur e en utilisant le même matériau et la même technique d'épitaxie que ceux utilisés pour la couche 2 et on réalise à nouveau une implantation ionique dans cette couche 2' de manière à créer la zone 4'. Cette opération peut être répétée plusieurs fois. Puis, sur la dernière couche ainsi créée, on termine l'élaboration de la structure par une épitaxie classique donnant la couche 5. En général, pour éviter de guérir les défauts créés par l'implantation ionique, l'épitaxie de la couche 5 sera réalisée à la température la plus basse possible. De même, tous les traitements thermiques ultérieurs utilisés pour améliorer la qualité cristalline des couches épitaxiées 5,2,2' seront réalisés par des techniques telle que la technique de "recuit flash" qui permet d'obtenir un recuit de surface afin d'éviter le guérissement des défauts introduits intentionnellement par l'implantation ionique.

Selon une variante représentée à la figure 3 on peut, en utilisant le procédé de la présente invention, épitaxier des couches successives en utilisant des matériaux présentant des paramètres de maille très différents. Ainsi, sur la figure 3, on a réalisé une structure à trois couches, par exemple, une structure Si GaAs InP. Dans ce cas sur le substrat 1 en silicium, on a épitaxié une couche 2 de GaAs dans laquelle on a créé par implantation ionique une zone perturbée 4 puis on a épitaxié une couche finale 5 de GaAs. Ensuite sur la couche 5 on a épitaxié une couche 2a d'InP dans laquelle on a créé par implantation ionique une zone perturbée 4a et sur cette couche on a épitaxié une couche finale 5a en InP.

On décrira maintenant avec référence aux figures 4a à 4d une variante de réalisation du procédé de la présente invention. Ainsi, comme représenté sur la figure 4a, sur une première couche ou substrat 10 en un matériau présentant un paramètre de maille déterminé tel que du silicium, par exemple, on a déposé une précouche monomoléculaire 11 qui sert à stabiliser normalement la surface de silicium. Dans cette variante, la précouche 11 sert aussi de protection au silicium, si l'échantillon doit être sorti du bâti d'épitaxie lors de l'étape ultérieure d'implantation. Cette précouche peut être réalisée en arsenic, en gallium et même, dans ce cas, en arseniure de gallium éventuellement amorphe. Elle peut être plus épaisse et avoir d'autres fonctions, tel que l'isolement électrique, elle sera alors en Si, $CaF_2$. Ces matériaux ne sont pas limitatifs, on peut envisager Al As, $Ga_{1-x}Al_xAs$, etc...

Comme représenté sur la figure 4b, on implante le substrat 10, à savoir le silicium, au travers de cette précouche 11 de manière à créer en surface (figure 4b) ou au sein (figure 4b') du silicium une zone monocristalline 13 très perturbée voire amorphe. La zone supérieure à cette zone amorphe sera perturbée et accommodera la différence de paramètres de maille avec moins de dislocations dans la couche épitaxiée. L'implantation est réalisée avec des ions $e^+12$ du même type que ceux mentionnés ci-dessus. Ensuite on soumet l'échantillon à un nettoyage qui peut être réalisé ex ou in-situ. Puis une fois le nettoyage réalisé, on reprend l'épitaxie de la couche en un matériau présentant un paramètre de maille différent tel que GaAs de manière à terminer l'échantillon. On obtient un échantillon présentant une couche finale 14 en GaAs tel que représenté sur la figure 4c.

Comme représenté sur la figure 4d, selon une variante de ce procédé, il est possible de créer des zones perturbées au-dessus de la précouche 11. Ainsi sur la couche 11 on fait croître par épitaxie une couche 16 du matériau présentant le paramètre de maille différent de celui du substrat 10 sur une épaisseur déterminée, puis par implantation ionique on crée dans cette couche 16 une zone perturbée 15 et ensuite, de la manière décrite ci-dessus pour le premier mode de réalisation, on fait croître par épitaxie une couche finale 17 réalisée dans le matériau présentant ledit paramètre de maille déterminé, à savoir GaAs dans le mode de réalisation représenté.

Selon une variante de réalisation pouvant être utilisée dans les deux procédés, l'implantation ionique est réalisée par des implantations successives d'ions différents de manière à créer des zones perturbées parallèles les unes aux autres dans la même couche épitaxiée 2 ou 16.

Selon une autre variante donnant un résultat sensiblement identique, l'implantation ionique est réalisée par des implantations successives d'un même ion à des énergies différentes. En effet, comme mentionné ci-dessus, la distance $R_P$ et la grandeur $\Delta R_P$ sont fonction du type d'ions ou des protons utilisés pour l'implantation ionique ainsi que de l'énergie appliquée, et de la charge de l'ion.

D'autre part, l'épitaxie peut être réalisée en utilisant tout procédé d'épitaxie connu et notamment l'épitaxie en phase vapeur, l'épitaxie en phase vapeur d'organométalliques (MOCVD), l'épitaxie par jets moléculaires (MBE), l'épitaxie par jets moléculaires d'organométalliques (MOMBE), l'épitaxie en phase liquide. Dans ce cas certains paramètres seront modifiés, notamment la température des cycles de recuit et la température d'épitaxie comme cela est bien connu de l'homme de l'art.

On décrira maintenant un exemple pratique de réalisation du procédé de la présente invention.

Dans cet exemple de réalisation pratique, on utilise comme procédé d'épitaxie, l'épitaxie par jets moléculaires. L'échantillon a été réalisé à partir d'un substrat en silicium. Tout d'abord on réalise un nettoyage ex-situ puis in-situ à haute température (à savoir entre 900 et 1000° C), de la surface du silicium pour retirer les oxydes volatils créés par la procédure de nettoyage ex-situ. Puis on dépose de manière connue une précouche monomoléculaire d'arsenic. Eventuellement la précouche peut être réalisée en gallium. Ensuite sur cette précouche on fait croître à basse température, à savoir à une température d'environ 300° C, pendant 100 Å une couche d'AsGa. Cette croissance est réalisée en utilisant une technique de flux alterné connue de l'homme de l'art sous le nom de MEE (Migration Enhanced Epitaxy). Puis on continue la croissance sur une épaisseur d'environ 800 Å en utilisant les conditions classiques du flux continu et simultané de Ga et As avec une vitesse de 0,5 $\mu$m/h à la même température, à savoir une température comprise entre 300 et 350° C.

Ensuite on réalise un cycle de recuit thermique in-situ à une température de 620° C. Les dislocations se forment à l'interface. On continue la croissance épitaxiale en flux couplé à 575° C jusqu'à ce que la couche épitaxiale présente une épaisseur de 3000 Å. On soumet alors l'échantillon à une implantation ionique d'ions argon sous une énergie de 300 KeV avec $10^{15}$ ions par cm². Cette implantation crée des points d'ancrage pour les dislocations se trouvant dans ce cas à une profondeur $R_P$ égale à 2052 A et sur une largeur 2.35 x $\Delta$ Rp égale à 2.35 x 711 Å. En fait l'énergie des ions doit être telle qu'une zone en surface d'épaisseur variable, à savoir de l'ordre de quelques centaines d'Angströms pour les énergies ci-dessus, soit de qualité cristalline suffisante pour permettre une reprise d'épitaxie. Cette implantation d'ions a donc permis de créer une zone dont la périodicité cristalline est fortement désorganisée, voire même amorphisée. Une fois la zone perturbée créée, on reprend l'épitaxie à 580° C jusqu'à obtenir une couche de surface parfaitement cristalline puis à 575° C en utilisant la technique des flux continus et simultanés de GaAs. Cette épitaxie est réalisée jusqu'à ce que la couche de GaAs présente une épaisseur comprise entre 2,5 microns et 3,5 microns.

Il est évident pour l'homme de l'art que l'adaptation des mailles peut être de plus améliorée en utilisant les techniques classiques déjà connues, notamment en insérant des super-réseaux et/ou des puits quantiques dans la structure d'échantillon décrite ci-dessus. Le recuit à 620° C de la couche crue par MEE peut ne pas être nécessaire.

La description ci-dessus n'a été donnée qu'à titre d'exemple non limitatif. D'autres variantes peuvent être envisagées par l'homme de l'art sans sortir du cadre de l'invention. Notamment les exemples numériques et les exemples de matériaux utilisés n'ont été fournis que pour illustrer la description. En effet, les couches en matériau présentant des paramètres de maille différents peuvent être réalisées en matériaux semiconducteurs tels que le silicium, le germanium, les composés III-V, II-VI et IV-VI de la classification périodique des éléments. Eventuellement, l'une des couches peut être réalisée en matériau isolant choisi parmi $SrF_2$, $BaF_2$, $CaF_2$, $Ca_xSr_{1-x}F_2$, le zircone, le zircone-yttrium (YSZ), MgO, BeO, $Al_2O_3$ (corrindon, saphire), $SrTiO_3$, $BaTiO_3$, le diamant, le quartz, $SiO_2$.

## Revendications

1. Procédé de fabrication de couches monocristallines de matériaux à paramètres de maille différents dans lequel on dépose par épitaxie sur une première couche (1,10) en un matériau présentant un paramètre de maille déterminé au moins une couche (5,14,17) monocristalline supplémentaire en un matériau présentant un paramètre de maille différent de celui de la couche adjacente, caractérisé en ce que l'on crée par implantation ionique dans la deuxième couche ou au niveau de la jonction entre deux couches au moins une zone (4,13) limitant la propagation des dislocations.

2. Procédé selon la revendication 1, caractérisé en ce qu'il comporte les étapes suivantes :
- une première étape de dépôt par épitaxie sur une première couche (1) en un matériau présentant un paramètre de maille déterminée, d'une deuxième couche (2) d'épaisseur déterminée en un matériau présentant un paramètre de maille différent de celui de la première couche,
- une deuxième étape d'implantation ionique de manière à créer dans la deuxième couche une zone (4) limitant la propagation des dislocations, et au moins
- une troisième étape de dépôt par épitaxie sur la deuxième couche d'une troisième couche (5) réalisée dans le même matériau que celui de la deuxième couche.

3. Procédé selon la revendication 2, caractérisé en ce que, avant la première étape de dépôt par épitaxie, la première couche est recouverte d'une précouche (6) d'adaptation monomoléculaire ou plus épaisse.

4. Procédé selon l'une quelconque des revendications 2 et 3, caractérisé en ce que la deuxième étape d'implantation ionique est précédée d'un cycle de recuits thermiques classique ou de surface.

5. Procédé selon l'une quelconque des revendications 2 à 4, caractérisé en ce que les étapes 1 et 2 sont répétées plusieurs fois avant de mettre en oeuvre la troisième étape.

6. Procédé selon l'une quelconque des revendications 2 à 5, caractérisé en ce que les étapes 1 à 3 sont répétées plusieurs fois avec des couches (2, 2a, 5, 5a) présentant des paramètres de maille différents.

7. Procédé selon l'une quelconque des revendications 2 à 6, caractérisé en ce que l'épaisseur de la deuxième couche est fonction de la grandeur $\Delta$ Rp caractéristiaue de l'ion et de l'énergie d'implantation utilisés.

8. Procédé selon la revendication 1, caractérisé en ce qu'il comporte les étapes suivantes :

- une première étape de dépôt sur une première couche (10) en un matériau présentant un paramètre de maille déterminée d'une précouche (11) d'adaptation monomoléculaire, ou plus épaisse.

- une deuxième étape d'implantation ionique de manière à créer en surface ou au sein de la première couche (10) une zone perturbée (13) limitant les dislocations,

- une troisième étape de nettoyage, et

- une quatrième étape de dépôt par épitaxie d'une deuxième couche (14) en un matériau présentant un paramètre de maille différent de celui de la première couche.

9. Procédé selon la revendication 8, caractérisé en ce qu'il comporte de plus :

- une cinquième étape d'implantation ionique de manière à créer dans la deuxième couche (16) une zone (15) limitant la propagation des dislocations, et

- une sixième étape de dépôt par épitaxie sur la deuxième couche d'une troisième couche (17) réalisée dans le même matériau que celui de la deuxième couche.

10. Procédé selon l'une quelconque des revendications 1 à 9, caractérisé en ce que l'implantation ionique est réalisée à l'aide de protons ou d'ions tels que : le manganèse, l'aluminium, le silicium, le chrome, le fer, le nickel, le cobalt, le cuivre, le germanium, l'étain, le sélénium, le tellure l'erbium, le vanadium, le béryllium, le zinc, le cadmium, le bore, le chlore, l'arsenic, le gallium, l'indium, le phosphore, le lithium, l'or, le tungstèe, le carbone, le titane, l'argent, l'azote, l'oxygène, le soufre, l'hydrogène, le fluor, le brome, l'argon, le krypton, le néon et/ou tous types d'ions susceptibles d'être implantés et de créer des défauts dans la première couche épitaxiée.

11. Procédé selon l'une quelconque des revendications 1 à 10, caractérisé en ce que l'implantation ionique est constituée par des implantations successives d'ions différents.

12. Procédé selon l'une quelconque des revendications 1 à 11, caractérisé en ce que l'implantation ionique est constituée par des implantations successives d'un même ion à des énergies différentes.

13. Procédé selon l'une quelconque des revendications 1 à 12, caractérisé en ce que les couches en matériau présentant des paramètres de maille différents sont réalisées en matériaux semiconducteurs. L'un d'entre eux pouvant être un isolant.

14. Procédé selon la revendication 12, caractérisé en ce que l'une des couches en matériau présentant des paramètres de maille différents est réalisée en un matériau isolant.

15. procédé selon la revendication 13, caractérisé en ce que le matériau semiconducteur est choisi parmi le silicium, le germanium, les composés III-V, II-VI et IV-VI de la classification périodique des éléments.

16. Procédé selon la revendication 14, caractérisé en ce que le matériau isolant est choisi parmi $SrF_2$, $BaF_2$, $CaF_2$, $Ca_xSr_{1-x}F_2$, zircone, zircone-yttrium (YSZ), MgO, BeO, $Al_2O_z$ (corrindon, saphire), $SrTiO_z$, $BaTiO_z$, le diamant, le quartz, $SiO_2$.

17. Procédé selon l'une quelconque des revendications 1 à 14, caractérisé en ce que le dépôt par épitaxie est réalisé par épitaxie en phase vapeur, par épitaxie en phase vapeur d'organométalliques (MOCVD), par épitaxie par jets moléculaires (MBE), par épitaxie par jets moléculaires d'organométalliques (MOMBE), par épitaxie en phase liquide.

18. Procédé selon l'une quelconque des revendications 2,6,7,8, caractérisé en ce que le dépôt par épitaxie de la dernière couche est réalisé à température basse.

19. Procédé selon l'une quelconque des revendications 1 à 18, caractérisé en ce que la couche supérieure est soumise à un "recuit flash".

FIG_1a

FIG_1b

FIG_1c

FIG_2

FIG_3

FIG_4a

FIG_4b

FIG_4c

FIG_4d

FIG_4b'

**Office européen des brevets**

# RAPPORT DE RECHERCHE EUROPEENNE

Numéro de la demande

## EP 90 40 2189

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EXTENDED ABSTRACTS, vol. 86-1, no. 1, mai 1986, pages 115-116, Pennington, NJ, US; M.T. DUFFY et al.: "Characterization of solid-phase regrown silicon films on sapphire" * Document en entier * | 1,10,13, 15,17 | H 01 L 21/20 C 30 B 31/22 |
| A | IDEM | 2 | |
| X | IEEE INTERNATIONAL ELECTRON DEVICES MEETING 1985, Washinton, DC, 1-4 décembre 1985, pages 676-679; D.C. MAYER et al.: "A high-speed submicrometer CMOS/SOS process in SPEAR material" * Pages 676-677: "Material preparation"; figure 1 * | 1,10,13, 15,17 | |
| X | IEE PROCEEDINGS SECTION A à I, vol. 133, no. 3, partie 1, juin 1986, pages 66-76, Hitchins, Herts, GB; S.L. PARTRIDGE: "Silicon-on-insulator technology" * Pages 67-68, paragraphe 3.1: "Expitaxial silicon on sapphire"; figures 4,5 * | 1,10,13, 15,17 | |
| A | EXTENDED ABSTRACTS OF THE 19TH CONFERENCE ON SOLID STATE DEVICES AND MATERIALS, Tokyo, 25-27 août 1987, pages 143-146; S. NARITSUKA et al.: "Growth of GaAs layers on (001) Si substrates" | | **DOMAINES TECHNIQUES RECHERCHES (Int. Cl.5)** H 01 L C 30 B |
| A | APPLIED PHYSICS LETTERS, vol. 51, no. 22, 30 novembre 1987, pages 1801-1803, New York, NY, US; J. VARRIO et.: "New approach to growth of high-quality GaAs layers on Si substrates" | | |

Le présent rapport de recherche a été établi pour toutes les revendications

| Lieu de la recherche | Date d'achèvement de la recherche | Examinateur |
|---|---|---|
| La Haye | 24 octobre 90 | GELEBART Y.C.M. |

CATEGORIE DES DOCUMENTS CITES
X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

& : membre de la même famille, document correspondant